# EUROPEAN PATENT APPLICATION

(11) **EP 1 191 597 A2**
(43) Date of publication of application: **27.03.2002**
(21) Application number: 01000490.1
(22) Date of filing: 20.09.2001
(51) Int. Cl.: H01L 27/115, H01L 21/8247, H01L 21/28, H01L 21/336

(54) **Sidewall process to improve the flash memory cell performance**

(30) Priority: 21.09.2000 US 234275
(71) Applicant: Texas Instruments Inc., Dallas, Texas 75251 (US)
(72) Inventor: Ambrose, Thomas M., Texas 75206, Dallas (US); Mehrad, Freidoon, Texas 75023, Plano (US); Yuan, Jessie, Texas 75082, Richardson (US)
(74) Representative: Holt, Michael

(57) **Abstract**

A method of forming a FLASH memory device having a conductive line (24) which crosses a trench isolation structure (70). The method involves forming nitride sidewalls (125) to protect the stack during the SAS etch process.

## Description

### TECHNICAL FIELD OF THE INVENTION

This invention relates generally to the field of electronic devices and more particularly to a sidewall process method for improving flash memory cell performance.

### BACKGROUND OF THE INVENTION

Electronic equipment such as televisions, telephones, radios, and computers are often constructed using semiconductor components, such as integrated circuits, memory chips, and the like. The semiconductor components are typically constructed from various microelectronic devices fabricated on a semiconductor substrate, such as transistors, capacitors, diodes, resistors, and the like. Each microelectronic device is typically a pattern of conductor, semiconductor, and insulator regions formed on the semiconductor substrate.

The density of the microelectronic devices on the semiconductor substrate may be increased by decreasing spacing between each of the various semiconductor devices. The decrease in spacing allows a larger number of such microelectronic devices to be formed on the semiconductor substrate. As a result, the computing power and speed of the semiconductor component may be greatly improved.

FLASH memory, also known as FLASH EPROM or FLASH EEPROM, is a semiconductor component that is formed from an array of memory cells with each cell having a floating gate transistor. Data can be written to each cell within the array, but the data is erased in blocks of cells. Each cell is a floating gate transistor having a source, drain, floating gate, and a control gate. The floating gate uses channel hot electrons for writing from the drain and uses Fowler-Nordheim tunneling for erasure from the source. The sources of each floating gate in each cell in a row of the array are connected to form a source line.

The floating gate transistors are electrically isolated from one another by an isolation structure. One type of isolation structure used is a LOCal Oxidation of Silicon (LOCOS) structure. LOCOS structures are generally formed by thermally growing a localized oxidation layer between the cells to electrically isolate the cells. One problem with the LOCOS structure is that the structure includes non-functional areas that waste valuable space on the semiconductor substrate.

Another type of isolation structure used is a Shallow Trench Isolation (STI). STI structures are generally formed by etching a trench between the cells and filling the trench with a suitable dielectric material. STI structures are smaller than LOCOS structures and allow the cells to be spaced closer together to increase the density of cells in the array. However, STI structures are often not used in FLASH memory due to the difficulty in forming the source line that connects the cells in each row. The source line in FLASH memory utilizing STI structures often has a higher resistance than a corresponding FLASH memory that uses LOCOS structures. The increased electrical resistance reduces the operational performance of the memory. With the current trend to reducing circuit size, STI isolation structures are being extensively used.

In a flash memory cell array using STI isolation structures, in order to form continuous source diffusion lines, a self-aligned source (SAS) pattern is used to etch about 4000Å of STI field oxide. This STI oxide etch results in exposing all the silicon in the source line. The SAS etch is followed by an implantation process where n-type dopants are implanted to create diffused continuous source lines. During SAS etch one side of the stacked wordline is exposed to the STI oxide etch. The existing thin oxide on the side of the wordline cannot protect the sides of the stacked wordline during the SAS etch because it is removed during the oxide etching process exposing the side of the stacked wordline to the SAS etch. The main problem with exposing the side of the stacked wordline to the SAS etch is that this etch will undercut the inter-polysilicon dielectric and gate dielectric causing an increase in the flash cell data retention loss. There is therefore a need for a method of protecting the side of the stacked wordline during the SAS etching process.

### SUMMARY OF THE INVENTION

The instant invention is a method for forming a FLASH memory device. In particular the method comprises etching a blanket silicon nitride film to form sidewall structures before performing a self aligned source etch process. The method will result in reduced data retention loss, faster cell erase times, a reduction in polysilicon etching time, and no additional process complexity.

### BRIEF DESCRIPTION OF THE DRAWINGS

For a more complete understanding of the present invention and the advantages thereof, reference is now made to the following description taken in conjunction with the accompanying drawings, wherein like reference numerals represent like features, in which:
FIGURE 1 is an electrical schematic diagram, in partial block diagram form, of an electronic device which includes a memory cell array;
FIGURE 2 is an enlarged plan view of a portion of the memory cell of FIGURE 1 array;
FIGURE 3 is a perspective view of a portion of the memory cell array of FIGURE 2;
FIGURES 4A - 4B are cross sections of the semiconductor substrate which illustrate the fabrication of a sidewall nitride according to an embodiment of the instant invention.
FIGURE 5 is a cross-section showing the completed structure according to an embodiment of the instant invention.

### DETAILED DESCRIPTION OF THE INVENTION

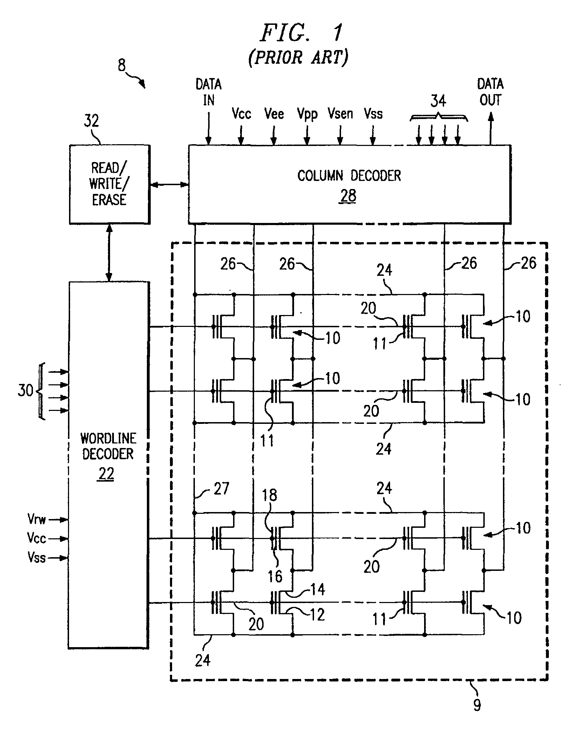

FIGURES 1 through 5 illustrates various aspects of an electronic device and the fabrication of a source line used within the electronic device. As described in greater detail below, the method of the instant invention can be used to fabricate a source line having a reduced electrical resistance.

FIGURE 1 is an electrical schematic diagram, in partial block form, of an electronic device 8 into which the invention may be incorporated. The electronic device 8 includes a wordline decoder 22, a column decoder 28, a Read/Write/Erase control circuit 32 for controlling the decoders 22 and 28, and a memory cell array 9. The memory cell array 9 comprises a number of memory cells 10 arranged in rows and columns. Each memory cell 10 includes a floating-gate transistor 11 having a source 12, a drain 14, a floating gate 16, and a control gate 18.

Each of the control gates 18 in a row of cells 10 is coupled to a wordline 20, and each of the wordlines 20 is coupled to the wordline decoder 22. Each of the sources 12 in a row of cells 10 is coupled to a source line 24. Each of the drains 14 in a column of cells 10 is coupled to a drain-column line 26. Each of the source lines 24 is coupled by a column line 27 to the column decoder 28 and each of the drain-column lines 26 is coupled to the column decoder 28.

In a write or program mode, the wordline decoder 22 may function, in response to wordline address signals on lines 30 and to signals from the Read/Write/Erase control circuit 32 to place a preselected first programming voltage V_{RW}, approximately +12V, on a selected wordline 20, which is coupled to the control gate 18 of a selected cell 10. Column decoder 28 also functions to place a second programming voltage V_{PP}, approximately +5 to +10V, on a selected drain-column line 26 and, therefore, the drain 14 of the selected cell 10. Source lines 24 are coupled to a reference potential V_{SS} through line 27. All of the deselected drain-column lines 26 are coupled to the reference potential V_{SS}. These programming voltages create a high current (drain 14 to source 12) condition in the channel of the selected memory cell 10, resulting in the generation near the drain-channel junction of channel-hot electrons and avalanche breakdown electrons that are injected across the gate oxide to the floating gate 16 of the selected cell 10. The programming time is selected to be sufficiently long to program the floating gate 16 with a negative program charge of approximately -2V to -6V with respect to the gate region. For memory cells 10 fabricated in accordance with an embodiment of the present invention, the coupling coefficient between the control gate 18, the wordline 20, and the floating gate 16 is approximately 0.5. Therefore, a programming voltage V_{RW} of 12 volts, for example, on a selected wordline 20, which includes the selected gate control 18, places a voltage of approximately +5 to +6V on the selected floating gate 16.

The floating gate 16 of the selected cell 10 is charged with channel-hot electrons during programming, and the electrons in turn render the source-drain path under the floating gate 16 of the selected cell 10 nonconductive, a state which is read as a "zero" bit. Deselected cells 10 have source-drain paths under the floating gate 16 that remain conductive, and those cells 10 are read as "one" bits.

In a flash erase mode, the column decoder 28 functions to leave all drain-column lines 26 floating. The wordline decoder 22 functions to connect all of the word lines 20 to the reference potential V_{SS}. The column decoder 28 also functions to apply a high positive voltage V_{EE}, approximately +10V to +15V, to all of the source lines 24. These erasing voltages create sufficient field strength across the tunneling area between floating gate 16 and the semiconductor substrate to generate a Fowler-Nordheim tunnel current that transfers charge from the floating gate 16, thereby erasing the memory cell 10.

In the read mode, the wordline decoder 22 functions, in response to wordline address signals on lines 30 and to signals from Read/Write/Erase control circuit 32, to apply a preselected positive voltage V_{CC}, approximately +5V, to the selected wordline 20, and to apply a low voltage, ground or V_{SS}, to deselected wordlines 20. The column decoder 28 functions to apply a preselected positive voltage V_{SEN}, approximately +1.0V, to at least the selected drain column line 28 and to apply a low voltage to the source line 24. The column decoder 28 also functions, in response to a signal on an address line 34, to connect the selected drain-column line 26 of the selected cell 10 to the DATA OUT terminal. The conductive or non-conductive state of the cell 10 coupled to the selected drain-column line 26 and the selected wordline 20 is detected by a sense amplifier (not shown) coupled to the DATA OUT terminal. The read voltages applied to the memory array 9 are sufficient to determine channel impedance for a selected cell 10 but are insufficient to create either hot-carrier injection or Fowler-Nordheim tunneling that would disturb the charge condition of any floating gate 16.

For convenience, a table of read, write and erase voltages is given in TABLE 1 below:

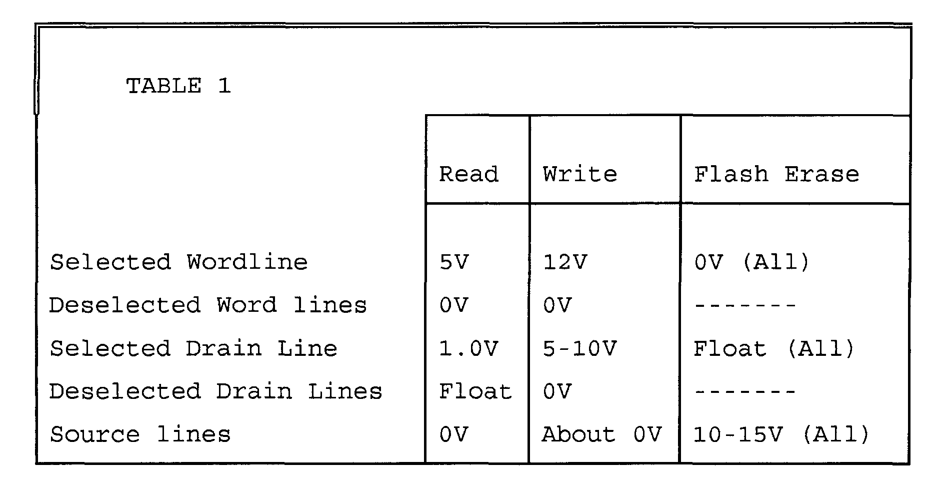

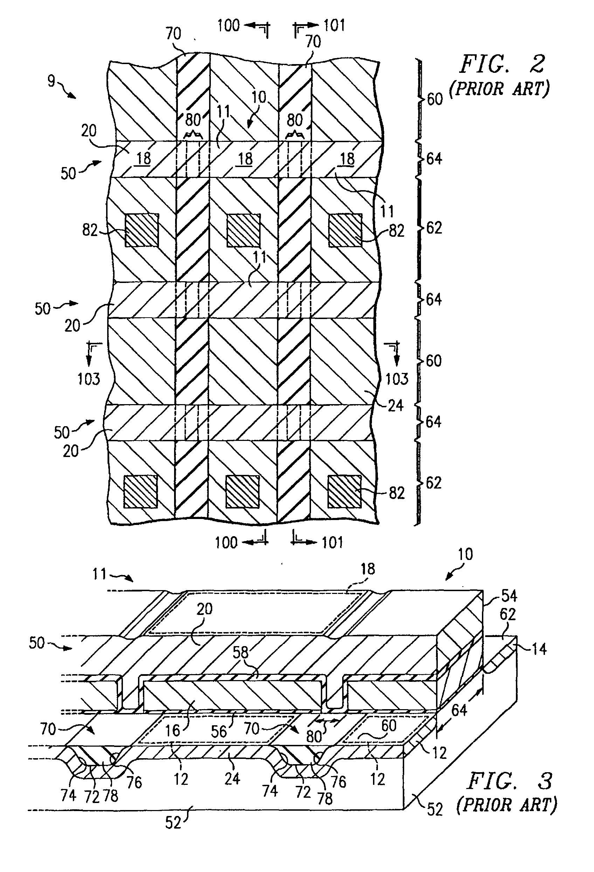

FIGURES 2 and 3 illustrate the structure of a portion of the memory array 9 illustrated in FIGURE 1. Specifically, FIGURE 2 is an enlarged plan view of a portion of a memory array 9, and FIGURE 3 is a perspective view of a portion of the memory array 9 illustrated in FIGURE 2. As discussed previously, the memory array 9 includes a number of memory cells 10 arranged in rows and columns.

As best illustrated in FIGURE 3, each row of memory cells 10 is formed from a continuous stack structure 50 that includes a number of memory cells 10. The floating gate transistor 11 within each memory cell 10 is formed on a semiconductor substrate 52 and separated from each adjacent memory cell 10 in the continuous stack structure 50 by a shallow trench isolation structure 70. The semiconductor substrate 52 includes a source region 60 and a drain region 62 separated by a channel region 64. The floating gate transistor 11 is generally fabricated by forming a gate stack 54 outwardly from a portion of the channel region 64 and doping a portion of the source region 60 and a portion of the drain region 62 adjacent the gate stack 54 to form a source 12 and a drain 14, respectively.

The semiconductor substrate 52 may comprise a wafer formed from a single-crystalline silicon material. For example, the semiconductor substrate 52 may include an epitaxial layer, a recrystallized semiconductor material, a polycrystalline semiconductor material, or any other suitable semiconductor material.

The regions 60, 62, and 64 are substantially parallel and may extend the length of the memory array 9. The channel region 64 of the semiconductor substrate 52 is doped with impurities to form a semiconductive region. The channel region 64 of the semiconductor substrate 12 may be doped with p-type or n-type impurities to change the operating characteristics of a microelectronic device (not shown) formed on the doped semiconductor substrate 52.

As best illustrated in FIGURE 3, the floating gate transistors 11 in each continuous stack structure 50 in the memory array 9 are electrically isolated from one another by the shallow trench isolation (STI) structure 70. The STI structures 70 are generally formed prior to the fabrication of the gate stack 54 on the semiconductor substrate 52. The STI structures 70 are formed by etching a trench 72 into the semiconductor substrate 52. The trench 72 is generally on the order of 0.3 to 8.5 □m in depth. The trench 72 comprises a first sidewall surface 74 and a second sidewall surface 76. As discussed in greater detail below, the sidewall surfaces 74 and 76 may be fabricated at an angle to vary the cross-sectional shape of the trench 72.

The trench 72 is then filled with a trench dielectric material 78 to electrically isolate the active regions of the semiconductor substrate 52 between the STI structures 70. The trench dielectric material 78 may comprise silicon dioxide, silicon nitride, or a combination thereof. The trench dielectric material 78 is generally etched back, followed by a deglaze process to clean the surface of the semiconductor substrate 52 prior to fabrication of the gate stack 54.

The continuous stack structure 50 is then fabricated outwardly from the semiconductor substrate 52 and the filled trench 72. The continuous stack structure 50 is formed from a series of gate stacks 54 fabricated outwardly from the channel region 64 of the semiconductor substrate 52. As best shown in FIGURE 3, the gate stack 54 comprises a gate insulator 56, the floating gate 16, an interstitial dielectric 58, and the control gate 18. The gate insulator 56 is formed outwardly from the semiconductor substrate 52, and the floating gate 16 is formed outwardly from the gate insulator 56. The interstitial dielectric 58 is formed between the floating gate 16 and the control gate 18 and operates to electrically isolate the floating gate 16 from the control gate 18.

The gate insulator 56 is generally grown on the surface of the semiconductor substrate 52. The gate insulator 56 may comprise oxide or nitride on the order of 100 to 500 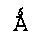 in thickness. The floating gate 16 and the control gate 18 are conductive regions. The gates 16 and 18 generally comprise a polycrystalline silicon material (polysilicon) that is in-situ doped with impurities to render the polysilicon conductive. The thickness' of the gates 16 and 18 are generally on the order of 100 nanometers and 300 nanometers, respectively. The interstitial dielectric 58 may comprise oxide, nitride, or a heterostructure formed by alternating layers of oxide and nitride. The interstitial dielectric 58 is on the order of 20 to 40 nanometers in thickness.

As best illustrated in FIGURE 2, the control gate 18 of each floating gate transistor 11 is electrically coupled to the control gates 18 of adjacent floating gate transistors 11 within adjacent continuous stack structures 50 to form a continuous conductive path. In the context of the memory array 9 discussed with reference to FIGURE 1, the continuous line of control gates 18 operate as the wordline 20 of the memory array 9. In contrast, the floating gate 16 of each floating gate transistor 11 is not electrically coupled to the floating gate 16 of any other floating gate transistor 11. Thus, the floating gate 16 in each floating gate transistor 11 is electrically isolated from all other floating gates 16. In one embodiment, the floating gates 16 in adjacent memory cells 10 are isolated by a gap 80. The gap 80 is generally etched into a layer of conductive material (not shown) that is used to form the floating gate 16.

The source 12 and the drain 14 of the floating gate transistor 11 are formed within a portion of the source region 60 and the drain region 62 of the semiconductor substrate 52, respectively. The source 12 and the drain 14 comprise portions of the semiconductor substrate 52 into which impurities have been introduced to form a conductive region. The drains 14 of each floating gate transistor 11 in a column are electrically coupled to each other by a number of drain contacts 82 to form the drain column line 26 (not shown). The drain column line 26 is generally formed outwardly from the wordline 20. As will be discussed in greater detail below, the source 12 of each floating gate transistor 11 forms a portion of the source line 24 and is formed during the fabrication of the source line 24.

As best illustrated in FIGURE 3, a portion of the source line 24 forms the source 12 of the floating gate transistor 11. The source line 24 connects the sources 12 to each other by a continuous conductive region formed within the semiconductor substrate 52 proximate the source region 60. As best illustrated in FIGURE 3, the source line 24 crosses the STI structures 70 in the source region 60 of the semiconductor substrate 52 below the STI structures 70. In contrast, the STI structures 70 electrically isolate the adjacent floating gate transistors 11 in the channel region 64 of the semiconductor substrate. During the formation of the source line 24, the isolation material 70 is removed from the trench during the self aligned source (SAS) etch process. The SAS implants are performed to form the conductive region 24 and the isolation material replaced during subsequent processes.

The source line 24, and correspondingly the sources 12 of each floating gate transistor 11, is generally fabricated after at least a portion of the gate stack 54 has been fabricated. The gate stack 54 is pattern masked (not shown) using conventional photolithography techniques, leaving the semiconductor substrate 52, proximate the source region 60, exposed. The exposed region of the semiconductor substrate 52 is then etched to remove the trench dielectric material 78 in the exposed region. The etching process to remove the trench dielectric material 78 may be an anisotropic etching process. Anisotropic etching may be performed using a reactive ion etch (RIE) process using carbon-fluorine based gases such as CF₄ or CHF₃.

The semiconductor substrate 52 proximate the source region 60, including that portion of the semiconductor substrate 52 forming the trench 72, is doped with impurities to render the region conductive. The conductive region is then thermally treated to diffuse the impurities into the source region 60 of the semiconductor substrate 52. The diffused conductive region forms both the source 12 of each floating gate transistor 11 as well as the source line 24. The source region 60 of the semiconductor substrate 52 is generally doped by an implantation process in which dopant ions are impacted into the semiconductor substrate 52.

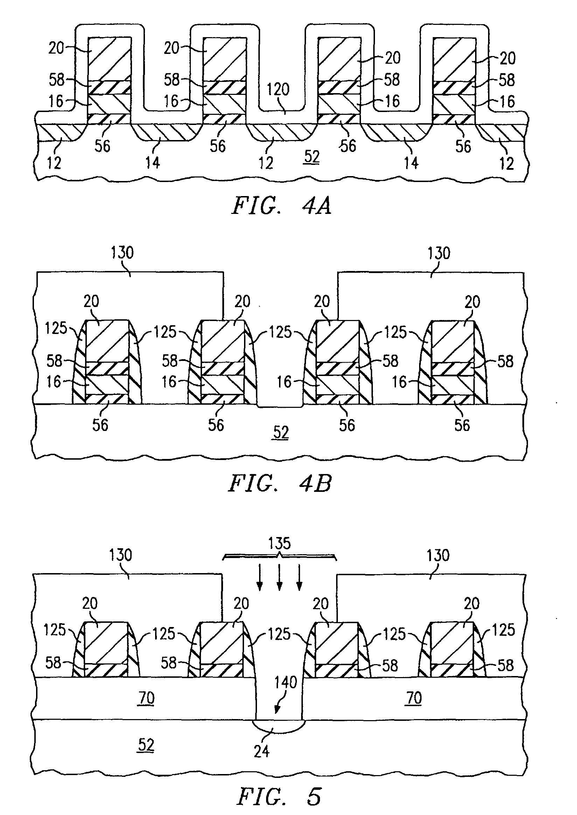

FIGURES 4A - 4B are cross sections of the semiconductor substrate 52 in the plane shown by line 100 in FIGURE 2. These figures will illustrate the fabrication of a SAS line 24 using sidewall processes. The other features of the integrated circuit that exist on the substrate (as discussed above) have been omitted from the figure for clarity. FIGURE 4A is a cross-section of the semiconductor substrate taken in the 100 plane in FIGURE 2 showing the substrate 52, gate insulator 56, the floating gate 16, the polysilicon word line 20, the interstitial dielectric 58, the source region 12, and the drain region 14 which are formed within the source region 60 and the drain region 62 of the substrate 52 respectively. This structure is formed after stack etch and dopant impurity implantation and annealing to form the source region 12 and drain region 14 of each cell. As illustrated in Figure 4A, before SAS etch, a conformal film 120 is formed on the substrate. In a preferred embodiment of the instant invention this conformal film 120 is silicon nitride. This silicon nitride film 120 can be formed using a LPCVD process. Shown in Figure 4B is the structure of Figure 4A following a film etch process. In a preferred embodiment of the instant invention this process is an anisotropic etch process of the silicon nitride film which results in the formation of silicon nitride sidewall structures 125. This anisotropic etch process can comprise a plasma etch process using the gases CHF₃ + O₂ with a RF power level between 100 and 300 Watts. The sidewall structures 125 will protect the interstitial dielectric 58, the sides of the floating gate and the wordline 16, 20, the gate insulator 56, and the edge of the silicon substrate that is adjacent to the edge of the gate dielectric during the subsequent SAS etch process. Following the formation of the sidewall structures 125, a photoresist film is formed and patterned 130 to expose the regions of the isolation structures to be removed during the SAS etch process.

Shown in Figure 5 is a cross section of the semiconductor substrate 52 in the plane shown by line 101 in FIGURE 2. The wordline structures 20 and the interstitial dielectric films 58 are formed on the shallow trench isolation structure 70. During the film deposition and etch process described above with reference to figure 4A, sidewall structures 125 are also formed adjacent to the wordline structures 20 over the isolation structures 70 as shown in Figure 5. The patterned photoresist film 130 exposes the regions 135 in the shallow trench isolation structure 70 that will be removed during the trench etch process to form the source line. The trench oxide is etched using a standard dry oxide etch process exposing the silicon substrate beneath the trench 140. Following the source line etch process, the source line implantation process is performed. For the source line implantation process, an implantation of a dopant species is performed forming the source line structure 24. In one embodiment this dopant species is arsenic, phosphorous, antimony either singly or in combination. Following the source implant, the patterned resist film 130 is removed using standard processing techniques. The integrated circuit can then be completed using standard processing techniques. In an alternative aspect of the instant invention a method of forming an integrated circuit memory is provided. The method comprises the step of: providing a semiconductor substrate with a plurality of FLASH memory cells, each FLASH memory cell having a gate structure with a side surface adjacent a source, said FLASH memory cells being adjacent to a plurality of isolation structures; forming a blanket silicon nitride film over said semiconductor substrate; etching said blanket silicon nitride film to form sidewall structures; etching said isolation structures to form a source line by exposing a plurality of regions of said semiconductor substrate beneath said isolation structures; implanting said source line with a dopant species;

Preferably, the isolation structures are formed using shallow trench isolation or LOCOS.

The dopant species implanted may be selected from a group consisting of arsenic and phosphorous, and the step of etching said silicon nitride film may comprise performing a plasma etch using gases from the group consisting of CHF₃ and O₂.

Although the present invention has been described in relation to several preferred and illustrative embodiments, various changes and modifications may be suggested to one skilled in the art. It is intended that the present invention encompass such changes and modifications.

## Claims

1. A method of forming a FLASH memory device, said method comprising:
a) providing a semiconductor substrate with a plurality of memory devices and at least one isolation structure, said plurality of memory devices each having a floating gate and a source;
b) forming a blanket silicon nitride film over said semiconductor substrate;
c) etching said blanket silicon nitride film to form sidewall structures;
d) etching a portion of said isolation structure thereby exposing a region of said semiconductor substrate beneath said isolation structure; and
e) implanting said region of said semiconductor substrate beneath said isolation structure with a first species.

2. The method of claim 1, wherein said step of providing said substrate comprises providing a substrate having an isolation structure comprising shallow trench isolation or LOCOS.

3. The method of claim 1, wherein said step of forming said blanket silicon nitride film comprises forming said blanket silicon nitide film using LPCVD.

4. The method of claim 1, wherein said implanting step comprises implanting a first species that is selected from a group consisting of arsenic and phosphorous.
